Europäisches Patentamt

European Patent Office

Office européen des brevets

(11) Veröffentlichungsnummer: **0 463 564 A2**

# EUROPÄISCHE PATENTANMELDUNG

(21) Anmeldenummer: **91110131.9**

(51) Int. Cl.⁵: **H05K 7/18**, H05K 5/00

(22) Anmeldetag: **20.06.91**

(30) Priorität: **28.06.90 CH 2157/90**

(43) Veröffentlichungstag der Anmeldung:
**02.01.92 Patentblatt 92/01**

(84) Benannte Vertragsstaaten:
**DE FR GB IT**

(71) Anmelder: **Reichle + De-Massari AG**
**Elektro-Ingenieure**
**Binzstrasse 31**

**CH-8620 Wetzikon(CH)**

(72) Erfinder: **Reichle, Hans**
**Guldislooweg 16**
**CH-8620 Wetzikon(CH)**

(74) Vertreter: **Petschner, Goetz**
**Patentanwaltsbüro G. Petschner**
**Seidengasse 18**
**CH-8001 Zürich(CH)**

(54) **Gestellsystem für den Schwachstrom-Anlagebau.**

(57) Beim Gestellsystem für den Schwachstrom-Anlagebau sind die Vertikal-Träger (1,1') zu einem selbsttragenden Gestell zusammengefügte Säulen aus mindestens je einem, mindestens frontseitig offenen Kastenprofil, deren offenseitigen, kantennahen Flächen (2,2') Rasterperforationen (3,3') zur Montage von Systemelementen aufweisen, wobei die lichte Weite der Vertikalträger ein Mass für das verwendete System-Modul ist und sich die Vertikalträger auf einer gemeinsamen Bodenschiene (4) abstützen.

Daraus ergibt sich ein Gestellsystem, das allen zu stellenden Anforderungen genügen kann und insbesondere mit wenigen Grundelementen einen sehr individuellen und vielseitigen selbsttragenden Aufbau bei front- und rückseitiger Zugänglichkeit erlaubt und für eine mehrmodulare Anwendung geeignet ist.

*Fig. 3*

EP 0 463 564 A2

Die vorliegende Erfindung betrifft ein Gestellsystem für den Schwachstrom-Anlagebau, insbesondere für Verteiler-Anlagen, das aus mehreren Einheiten nach dem Baukastenprinzip zusammensetzbar ist, welche Einheiten insbesondere kabelführende Vertikal-Träger zum frontseitigen Befestigen von Anschlussleisten u. dgl. umfassen.

In der Telefonie oder anderen Signal-Uebertragungsbereichen gewinnen Gestellsysteme der vorgenannten Art ständig an Bedeutung, um die zahlenmässig erheblich wachsenden Zuleitungen übersichtlich und rationell andrahten zu können.

Hierbei wird angestrebt, solche Gestellsysteme als Baukästen auszubilden, um den Aufbau der Gestelle aus genormten Teilen auf Grund eines Baumusterplanes oder dgl. wirtschaftlich zu verbessern.

Dies wird mit den heutigen Mitteln allerdings nur unvollkommen erreicht, indem als Vertikalelemente lediglich U-Profile Verwendung finden, die nur für einen einzigen vorgegebenen Modul verwendbar und nicht ausreichend kompakt sind sowie in der Regel für freistehende Verteiler eine komplizierte Zusatzgestell-Konstruktion voraussetzen.

Es ist nun Aufgabe der vorliegenden Erfindung, ein Gestellsystem für den Schwachstrom-Anlagebau, insbesondere für Verteiler-Anlagen zu schaffen, das ohne weiteres an unterschiedliche Module angepasst werden kann, das ohne weiteres selbsttragend und freistehend aufgebaut werden kann, das einen sehr kompakten Aufbau gestaltet und das zudem frontseitig und rückseitig zugänglich ist.

Dies wird nun erfindungsgemäss zunächst dadurch erreicht, dass die Vertikalträger in ansich bekannter Weise U-profilartige, zur Frontseite hin offene Säulen sind, die zusammengefügt ein selbsttragendes Gestell bilden und deren offenseitigen kantennahen Flächen Rasterperforationen zur Montage von Systemelementen aufweisen, wobei die lichte Weite der Vertikalträger ein Mass für das System-Modul ist und sich die Vertikalträger auf mindestens einer gemeinsamen Bodenschiene o. dgl. abstützen.

Ein optimaler freier Zugang zum Gestell von unten her wird dann in erfindungswesentlicher Weise dadurch erreicht, dass die gemeinsame Bodenschiene eine über vertikale Auflager abgestützte Mittelschiene ist.

Hierbei ergibt sich dann eine vorteilhafte Ausgestaltung dadurch, dass die Vertikalträger selbsttragend aus Winkelprofilen zusammengesetzt sind, von welchen mindestens ein Paar eine frontseitig, gegebenenfalls rückseitig offene kastenprofilartige Säule bilden, wobei jene, die Seitenwände bildenden Winkelprofilabschnitte durch, den modularen System-Abstand bestimmende Distanzstege verbunden sind und dass zwei Winkelprofilpaare zu einer front- und rückseitig zugänglichen Doppelsäule zusammengefügt sind, wobei die, die Flansche bildenden Winkelprofilabschnitte jedes Winkelprofilpaares miteinander verbunden sind.

Entsprechend ist es für eine grosse Universalität zweckmässig, wenn die Winkelprofile Perforationen zur lösbaren Befestigung untereinander bzw. der Distanzstege bzw. von weiteren Einheiten des Systems aufweisen.

Eine kompakte, stabile, von allen Seiten zugängliche, freistehende Anordnung ergibt sich ferner dann, wenn die Säulen obere und untere Abdeckungen tragen, welche gleichzeitig Montagehilfen für eine obere Stabilisierungsschiene resp. Gestell-Füsse bilden.

Durch diese Massnahmen ist es nunmehr möglich, ein- und mehrmodulare selbsttragende Gestellsysteme an Ort aufzubauen mit allen Möglichkeiten der Kabeleinführung von oben und von unten insbesondere auch im Bereich von Doppelböden. Von grosser Bedeutung ist dabei der mehrmodulare Aufbau für einen direkten Uebergang von Verteilersystemen auf Instrumente tragende Gestellsysteme. So gelingt es nunmehr, beispielsweise das "VS 83"-System mit dem für Instrumente notwendige 19''-System in einem einzigen, freitragenden Gestell zu vereinen.

In einer weiteren Ausgestaltung der Erfindung können zudem die durch Säulen gebildeten Vertikalträger mit solchen in Horizontalerstreckung verbunden sein.

Beispielsweise Ausführungsformen des Erfindungsgegenstandes sind nachfolgend anhand der Zeichnung näher erläutert. Es zeigen:

Fig. 1 in schematischer Frontansicht ein erfindungsgemässes Gestellsystem in freitragender Bauweise (Standverteiler) mit zwei unterschiedlichen modularen Rasterprofilen;

Fig. 2 die Anordnung gemäss Fig. 1 in einem schematischen Teilgrundriss;

Fig. 3 die Anordnung gemäss den Fig. 1 und 2 in schaubildartiger, auseinandergezogener Darstellung; und

Fig. 4 eine Ausführungsvariante des erfindungsgemässen Gestellsystems in einmodularer Ausführung in schaubildartiger, auseinandergezogener Darstellung.

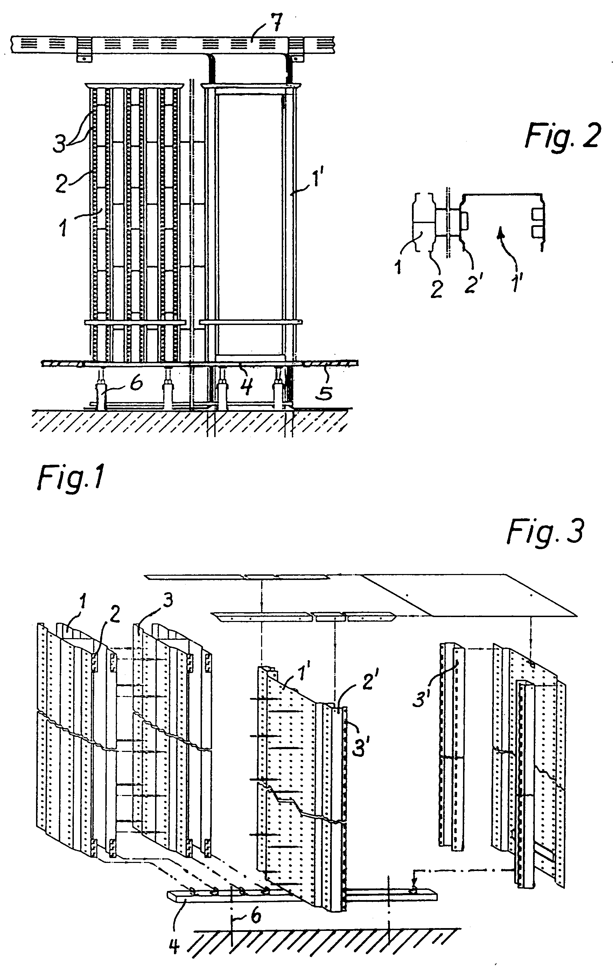

Das in den Fig. 1 bis 3 veranschaulichte Gestellsystem ist hier zweimodular aufgebaut und umfasst erste Vertikalträger 1 für einen sogenannten "VS 83"-Verteiler und einen zweiten Vertikalträger 1' für das Anbringen des heute üblichen 19''-Instrumentariums für die Signalübertragung von und zu in der Regel datenverarbeitenden Anlagen.

Die Vertikalträger 1 und 1' sind in ansich bekannter Weise U-profilartige, zur Frontseite hin offene Säulen, die zusammengefügt ein selbsttragendes Gestell bilden und deren offenseitigen kantennahen Flächen 2,2' Rasterperforationen 3 resp. 3' zur Montage von nicht näher gezeigten Systemelementen aufweisen (Fig. 3).

Wie insbesondere Fig. 2 erkennen lässt, ist dabei die lichte Weite jeder Säule 1 resp. 1' ein Mass des betreffenden Moduls. Ferner können die kantennahen Flächen 2 (Fig. 2) eingezogen oder die Flächen 2' (Fig. 2) parallelverlaufend sein.

Wie die Fig. 1 und 2 zeigen, stützen sich die Säulen 1 des ersten modularen Systems sowie die Säulen 1' des zweiten modularen Systems auf einer vorzugsweise mittleren Bodenschiene 4 ab, die bei einem Standort mit Doppelboden 5 (Fig. 1) auf vorzugsweise höhenverstellbare Auflager 6 abgestützt sind (Fig. 1). Dies gestattet eine optimale Kabelzu- und -einführung von unten, wobei die offene Bauweise ebenso eine Kabeleinführung von oben gestattet, wie das Fig. 1 mit dem oberen Kabelkanal 7 verdeutlicht.

Beim vorstehenden Gestellsystem sind hier die Vertikalträger 1 des ersten modularen Systems abgekantete Profile, wogegen der Vertikalträger 1' des zweiten modularen Systems baukastenmässig aus Winkelprofilen zusammengefügt ist, wie dies anhand von Fig. 3 erkennbar ist.

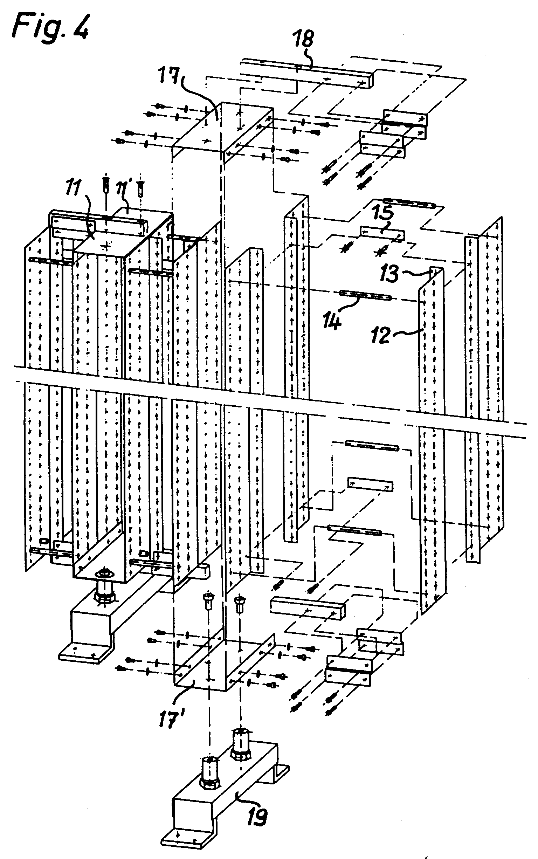

Neben diesem 19''-Gestellteil lässt sich auch der erstmodulare Gestellteil baukastenmässig an Ort erstellen, wie dies Fig. 4 für einen einmodularen "VS 83"-Verteiler zeigt.

Dieses Gestellsystem gemäss Fig. 4 umfasst jeweils zu einer Doppelsäule 11,11' zusammengefasste Vertikalträger, wobei jede einzelne Säule selbst aus zwei Winkelprofilen 12, 13 zusammengesetzt ist und so ein offenes Kastenprofil bildet. Hierbei sind jene, die Seitenwände 12 bildenden Winkelprofilabschnitte durch, den modularen System-Abstand bestimmende Distanzstege 14 verbunden. Weitere Distanzplättchen 15 oder dgl. können zudem die, die Flansche 13 bildenden Winkelprofilabschnitte verbinden, so dass eine selbsttragende, freistellbare Säule entsteht.

Eine kompakte Bauweise mit front- und rückseitig zugänglicher Doppelsäulen 11,11' ergibt sich dabei dadurch, dass die, die Flansche 13 bildenden Winkelprofilabschnitte jedes Winkelprofilpaares aneinanderliegend miteinander verbunden werden.

Solche Doppelsäulen 11,11' können dann in ihrem kanalartigen Bereich die Kabel führen, wobei die Distanzplättchen 15 an den Flanschen 13 die Kanäle der einzelnen Säulen 11 und 11' voneinander trennen und die Distanzstege 14 an der offenen Seite der Kanäle eine Sicherung gegen ein Herausfallen der Kabelstränge aus dem betreffenden Vertikal-Träger darstellen.

An diese Säulen lassen sich dann in üblicher Weise und wie anhand von Fig. 1 - 3 vorbeschrieben die dem gewählten Modul entsprechenden Anschlussleisten u. dgl. (nicht gezeigt) montieren.

Für einen freistehenden, allseitig zugänglichen, kompakten und stabilen Aufbau des Gestellsystems sind ferner obere 17 und untere Abdeckungen 17' mit den Säulen 11,11' verbindbar, welche gleichzeitig als Montagehilfen für die Montage von oberen Stabilisierungsschienen 18, die auch als Querkanäle ausgebildet sein können resp. Gestell-Füssen 19 dienen.

In gleicher Weise ist auch die Säule 1' des zweiten modularen Systems gemäss Fig. 1 bis 3 aufbaubar.

Zudem ist es möglich, die durch Säulen gebildeten Vertikalträger mit solchen gleicher Ausbildung in Horizontalerstreckung zu verbinden (nicht gezeigt).

Aus dem Vorbeschriebenen ergibt sich somit ein Gestellsystem für den Schwachstrom-Anlagebau, insbesondere für Verteiler-Anlagen, welches nunmehr allen zu stellenden Anforderungen genügt, wobei mit wenigen Grundelementen ein selbsttragender, individueller, sehr vielseitiger und insbesondere kompakter Aufbau erreicht wird bei einer optimalen front- und rückseitig zugänglichen Handhabung und wobei nunmehr insbesondere eine mehrmodulare Ausgestaltung möglich ist, beispielsweise die Vereinigung des "VS 83"-Kanalsystems mit einem 19''-Kanalsystem.

**Patentansprüche**

1. Gestellsystem für den Schwachstrom-Anlagebau, insbesondere für Verteiler-Anlagen, das aus mehreren Einheiten nach dem Baukastenprinzip zusammensetzbar ist, welche Einheiten insbesondere kabelführende Vertikalträger zum frontseitigen Befestigen von Anschlussleisten u. dgl. umfassen, dadurch gekennzeichnet, dass die Vertikalträger (1,1' resp. 11,11') in ansich bekannter Weise U-profilartige, zur Frontseite hin offene Säulen sind, die zusammengefügt ein selbsttragendes Gestell bilden und deren offenseitigen kantennahen Flächen (2,2') Rasterperforationen (3,3') zur Montage von Systemelementen aufweisen, wobei die lichte Weite der Vertikalträger ein Mass für das System-Modul ist und sich die Vertikalträger auf mindestens einer gemeinsamen Bodenschiene (4) od. dgl. (19) abstützen.

2. Gestellsystem nach Anspruch 1, dadurch ge-kennzeichnet, dass die gemeinsame Boden-schiene eine über vertikale Auflager (6) abgestützte Mittelschiene (4) ist.

3. Gestellsystem nach Anspruch 1, dadurch gekennzeichnet, dass die Vertikalträger (1 und/oder 1' resp. 11,11') selbsttragend aus Winkelprofilen (12,13) zusammengesetzt sind, von welchen mindestens ein Paar eine frontseitig, gegebenenfalls rückseitig offene kastenprofilartige Säule bilden, wobei jene, die Seitenwände (12) bildenden Winkelprofilabschnitte durch, den modularen System-Abstand bestimmende Distanzstege (14) verbunden sind.

4. Gestellsystem nach Anspruch 3, dadurch gekennzeichnet, dass zwei Winkelprofilpaare (11,11') zu einer front- und rückseitig zugänglichen Doppelsäule zusammengefügt sind, wobei die, die Flansche (13) bildenden Winkelprofilabschnitte jedes Winkelprofilpaares miteinander verbunden sind.

5. Gestellsystem nach Anspruch 3, dadurch gekennzeichnet, dass die Winkelprofile (12,13) Perforationen zur lösbaren Befestigung untereinander bzw. der Distanzstege (14) bzw. von weiteren Einheiten des Systems aufweisen.

6. Gestellsystem nach Anspruch 3, dadurch gekennzeichnet, dass die Säulen (11,11') obere und untere Abdeckungen (17,17') tragen, welche gleichzeitig Montagehilfen für eine obere Stabilisierungsschiene (18) resp. Gestell-Füsse (19) bilden.

7. Gestellsystem nach Anspruch 1, dadurch gekennzeichnet, dass die durch Säulen gebildeten Vertikalträger mit solchen in Horizontalerstreckung verbunden sind.

Fig. 2

Fig.1

Fig. 3

5

# Fig. 4